(19) Europäisches Patentamt

European Patent Office

Office européen des brevets

(11) **EP 4 531 110 A1**

(12) **EUROPEAN PATENT APPLICATION**

(43) Date of publication:
**02.04.2025 Bulletin 2025/14**

(21) Application number: **23201069.4**

(22) Date of filing: **29.09.2023**

(51) International Patent Classification (IPC):
*H01L 29/10* (2006.01)      *H01L 21/265* (2006.01)
*H01L 29/66* (2006.01)      *H01L 29/78* (2006.01)

(52) Cooperative Patent Classification (CPC):
**H10D 62/393; H01L 21/26586; H10D 30/0291;
H10D 30/66**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Nexperia B.V.
6534 AB Nijmegen (NL)**

(72) Inventors:
• **Teichrib, Jakob
  22529 Hamburg (DE)**
• **Stein, Falk-Ulrich
  22529 Hamburg (DE)**
• **Schumacher, Olrik
  22529 Hamburg (DE)**

(74) Representative: **Pjanovic, Ilija
  Nexperia B.V.
  Legal & IP
  Jonkerbosplein 52
  6534 AB Nijmegen (NL)**

(54) **SEMICONDUCTOR DEVICE AND METHOD OF MANUFACTURING SEMICONDUCTOR DEVICE**

(57)    The present disclosure relates to a semiconductor device and a method of manufacturing semiconductor device. The present disclosure relates particularly to MOSFET transistors.

A semiconductor device comprising a first-conductivity-type substrate, a first-conductivity-type epitaxy layer comprising a JFET region, two first well regions comprising two source regions, two second well regions, a scatter oxide layer, wherein the first-conductivity-type substrate is adjacent to the first-conductivity-type epitaxy layer, wherein the two first well regions are adjacent to the first-conductivity-type epitaxy layer and each of the two first well regions is adjacent to one second well region, wherein the JFET region is adjacent to the two second well regions, wherein the scatter oxide layer is adjacent to the two source regions, the two first well regions (8), the two second well region and the JFET region, wherein a width of the JFET region is greater near the scatter oxide layer than in part closest to the first-conductivity-type substrate.

Fig. 8

# Description

## TECHNICAL FIELD

The present disclosure relates to a semiconductor device and a method of manufacturing semiconductor device. The present disclosure relates particularly to MOSFET transistors.

## BACKGROUND OF THE DISCLOSURE

Transistors with a gate oxide, such as the metal-oxide-semiconductor field-effect transistor (MOSFET) can face the issue of elevated electric fields at the oxide. This is especially true for power MOSFETs operated at high voltages, e.g. those made from silicon carbide. Under normal operating conditions a high potential difference is created between the gate and drain terminal. If the electric field at the gate interface is too large, a deterioration or destruction of the oxide layer can occur, especially if imperfections in the oxide or interface material are present. The MOSFET might be rendered useless in such a case, as it would not be able to perform any switching actions.

Document US9184230B2 discloses a silicon carbide vertical field effect transistor includes a first-conductive-type silicon carbide substrate; a low-concentration first-conductive-type silicon carbide layer formed on a surface of the first-conductive-type silicon carbide substrate; second-conductive-type regions selectively formed on a surface of the first-conductive-type silicon carbide layer; first-conductive-type source regions formed in the second-conductive-type regions; a high-concentration second-conductive-type region formed between the first-conductive-type source regions in the second-conductive-type region; a source electrode electrically connected to the high-concentration second-conductive-type region and a first-conductive-type source region; a gate insulating film formed from the first-conductive-type source regions formed in adjacent second-conductive-type regions, onto the second-conductive-type regions and the first-conductive-type silicon carbide layer; a gate electrode formed on the gate insulating film; and a drain electrode on the back side of the first-conductive-type silicon carbide substrate, wherein an avalanche generating unit is disposed between the second-conductive-type region and the first-conductive-type silicon carbide layer.

Document US7728336B2 discloses that a SiC vertical MOSFET comprising a channel region and an n-type inverted electron guide path formed through ion implantation in a low-concentration p-type deposition film, the width of the channel region may be partly narrowed owing to implantation mask positioning failure, and the withstand voltage of the device may lower, and therefore, the device could hardly satisfy both low on-resistance and high withstand voltage. In the invention, second inverted layers are provided at the same distance on the right and left sides from the inverted layer to be the electron guide path in the device, and the inverted layers are formed through simultaneous ion implantation using the same mask, and accordingly, the length of all the channel regions in the device is made uniform, thereby solving the problem.

Document JP5368140B2 discloses a vertical MOSFET that uses SiC, a source region and a base region are formed by ion implantation using the same tapered mask to give the base region a tapered shape. The taper angle of the tapered mask is set to 30 to 60° when the material of the tapered mask has the same range as SiC does in ion implantation, and is set to 20 to 45° when the material of the tapered mask is SiO2.

Document JP5300658B2 discloses a MOSFET includes: an n-type SiC drift layer formed on an SiC substrate; a pair of p-type base regions formed above the SiC drift layer; and an n-type high-concentration layer formed at a depth of the bottom of the base region over the SiC drift layer and having a high impurity concentration than the SiC drift layer. The pair of base regions each include a first base region as an inner part of the pair of base regions, and a second base region formed deeper than the first base region outside it.

Accordingly, it is a goal of the present disclosure to reduce the electric field close to the gate oxide interface by widening the well regions at the bottom, which can have a shielding effect for the gate interface

## SUMMARY OF THE DISCLOSURE

According to a first example of the disclosure, a semiconductor device is disclosed. The semiconductor device comprising: a first-conductivity-type substrate, a first-conductivity-type epitaxy layer comprising a JFET region, two first doped well regions comprising two source regions, two second well regions, a source contact region, a gate oxide comprising a gate, a drain adjacent to the first-conductivity-type substrate. The first-conductivity-type substrate is adjacent to the first-conductivity-type epitaxy layer. The two first well regions are adjacent to the first-conductivity-type epitaxy layer and each of the two first well regions is adjacent to at least one second well region. The JFET region is adjacent to the two second well regions. A width of the JFET region is greater near a top surface than in part closest to the first-conductivity-type substrate. The top surface is a surface of the semiconductor device where first well regions and second well regions are located. The source contact region is the outermost layer and is adjacent to the two source regions. The gate oxide is adjacent to the two first well regions, the two second well regions, the two source regions, and the JFET region.

Preferably a change in the width of the JFET region is at least partially continuous and linear.

Preferably the change in the width of the JFET region is continuous and linear.

Preferably at least one side of the JFET region being a continuous and linear part of the change of the width of the JFET region forms an angle with a normal of the scatter oxide layer. The angle is greater than 0 degrees and wherein there is a gap between both sides of the JFET region.

Preferably each of both sides of the JFET region being a continuous and linear part of the change of the width of the JFET region forms the same angle, in terms of an absolute value, with a normal of the scatter oxide layer.

Preferably the angle is smaller than arctan($0,5b_{max}$/d), where b is the width of the JFET region closest to the scatter oxide layer and d is a depth of the second well region.

Preferably the first-conductivity-type epitaxy layer comprising a second first-conductivity-type layer such that at least JFET region is located within the second first-conductivity-type layer. The second-conductivity-type shield region has a higher dopant concentration than the first-conductivity-type epitaxy layer.

According to a second example of the disclosure a method of manufacturing a semiconductor device is disclosed. The method comprising steps of: a) depositing of a first-conductivity-type epitaxy layer on top of a first-conductivity-type substrate, b) depositing of a scatter oxide layer on top of the first-conductivity-type epitaxy layer, c) creating a first mask on the scatter oxide layer, d) implanting of a dopant by implantation of second-conductivity-type dopant in the area of both first well region and one second well region such that implantation of second-conductivity-type dopant is performed tilted, toward a first side, with respect to a normal of the scatter oxide layer, e) implanting of a dopant by implantation of second-conductivity-type dopant in the area of both first well region and other second well region such that implantation of second-conductivity-type dopant is performed tilted, toward other side, with respect to a normal of the scatter oxide layer, f) creating the second mask which is wider than the first mask, g) creating source regions by second implantation of first-conductivity-type dopant through the second mask.

Preferably the first mask fully protects the first-conductivity-type epitaxy layer from doping during steps d) and e).

Preferably the first mask has a lower penetration depth than first-conductivity-type epitaxy layer.

Preferably after step b), a second first-conductivity-type layer is created by a first implantation of first-conductivity-type dopant on the first-conductivity-type epitaxy layer.

Preferably during step f), the second mask is created by adding spacers to the first mask.

Preferably implantation of second-conductivity-type dopant is performed tilted during steps d) and e) is tilted by the same angle, in terms of an absolute value.

BRIEF DESCRIPTION OF THE DRAWINGS

The disclosure will now be discussed with reference to the drawings, which show in:

Figure 1 shows a cross-section of a semiconductor device prior to applying first masks,
Figure 2 shows a cross-section of the semiconductor device with the first masks applied,
Figure 3 shows a cross-section of the semiconductor device during a first step of creation of well regions,
Figure 4 shows a cross-section of the semiconductor device during a second step of creation of well regions,
Figure 5 shows an enlarged view of a cross-section of the semiconductor, more precisely of a JFET region,
Figure 6 shows a cross-section of the semiconductor device after the well regions where a mask's penetration depth is not negligible,
Figure 7 shows a cross-section of the semiconductor device with a second mask applied
Figure 8 shows a cross-section of the semiconductor device during a creation of source regions.

DETAILED DESCRIPTION OF THE DISCLOSURE

For a proper understanding of the disclosure, in the detailed description below corresponding elements or parts of the disclosure will be denoted with identical reference numerals in the drawings.

A core idea behind this invention is that second well regions 10 have a notch at the bottom part toward the JFET region 9. This causes the JFET region 9 to be wider at the top and narrower at the bottom.

First steps of manufacturing of a semiconductor device according to the invention are not shown in figures since those are the same steps as in the prior art methods. A first-conductivity-type substrate 1 is used as a substrate, on which a first-conductivity-type epitaxy layer 2 is deposited - this layer serves as a drift layer for the semiconductor device. Next, on top of the first-conductivity-type epitaxy layer 2, a scatter oxide layer 4 is deposited to improve the subsequent implant processes. It should be noted that the scatter oxide layer 4 is only needed for the manufacturing process. A final structure will not have the scatter oxide layer 4.

It should be noted that throughout the whole description terms "first-conductivity-type" and "second-conductivity-type" will be used. Since the semiconductor device will have regions made as a semiconductor (typically silicon or germanium) doped with impurities for the purpose of modulating semiconductor's properties. Since mentioned impurities either provide electrons (impurities are donors) or holes (impurities are acceptors) those regions are often referred to as n-type or p-type regions. In this description it should be understood that in the case that the first-conductivity-type may mean p-type, the second-conductivity-type will be n-type. The invention will also work the other way around. The Applicant wishes not to focus on an exact types of regions but rather on a general idea behind this invention.

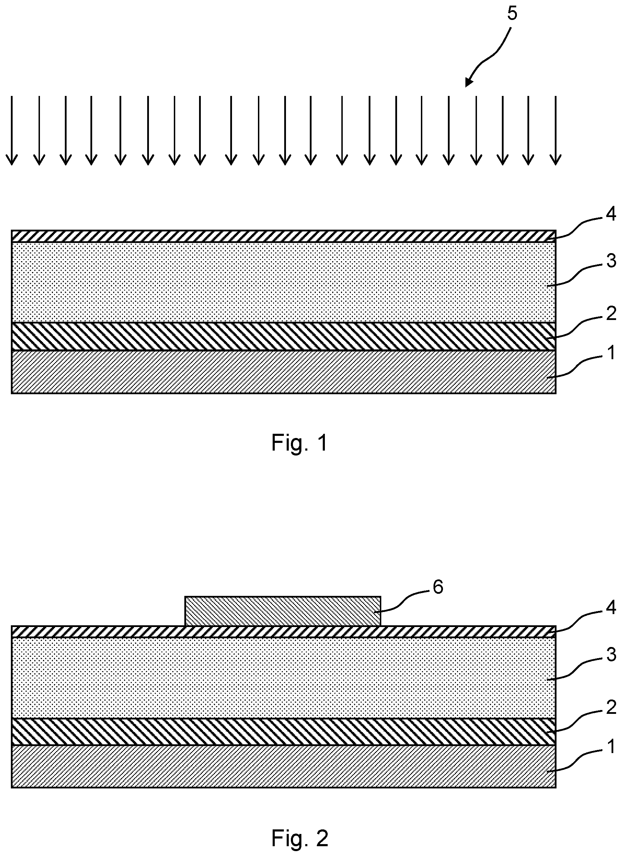

In fig. 1 an additional step of a surface-wide first implantation 5 of first-conductivity type is shown, which is forming a second first-conductivity-type layer 3 within the first-conductivity-type epitaxy layer 2, which would alter the JFET region 9. The first implantation 5 can be shallower or deeper than an implantation 7 of second-conductivity-type dopant, which will form well regions 10. In the following illustrations, a deeper variant is shown.

In fig. 2 a final effect of a next step is shown which is a formation of first masks 6.

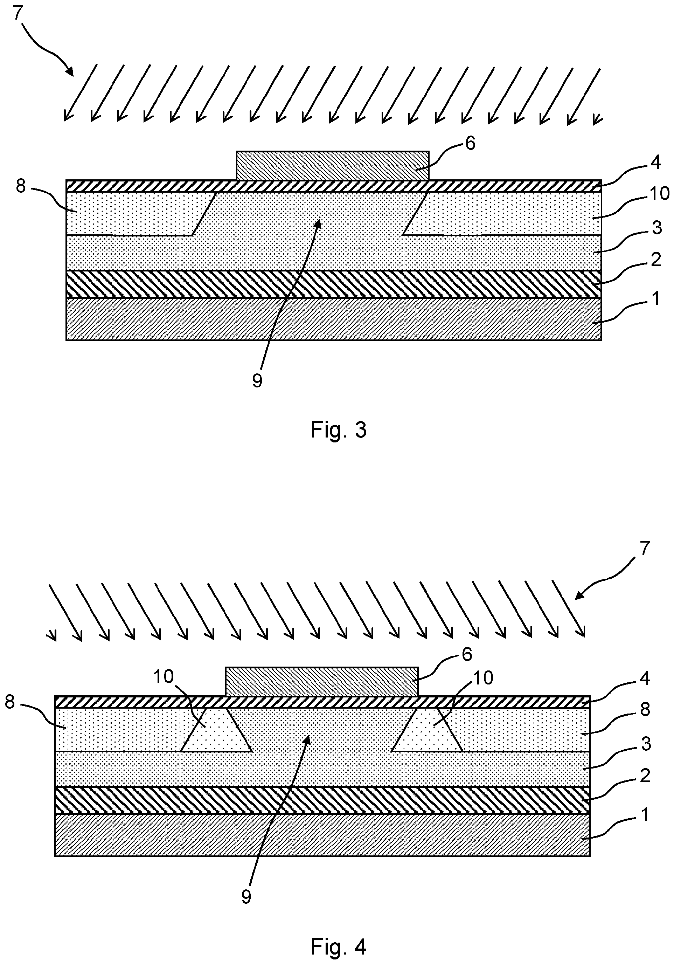

In figs. 3 and 4 a step of the implantation 7 of second-conductivity-type dopant is shown. The implantation 7 of second-conductivity-type dopant is performed in at least two sub-steps. A first sub-step is performed such that the implantation 7 of second-conductivity-type dopant is done angled toward one side, which is shown in fig. 3. As a result second well regions 10 are formed. During another sub-step the implantation 7 of second-conductivity-type dopant is done angled toward different side than previously - after this sub-step two well region types are present in the semiconductor device, namely two first well regions 8 and two second well regions 10.

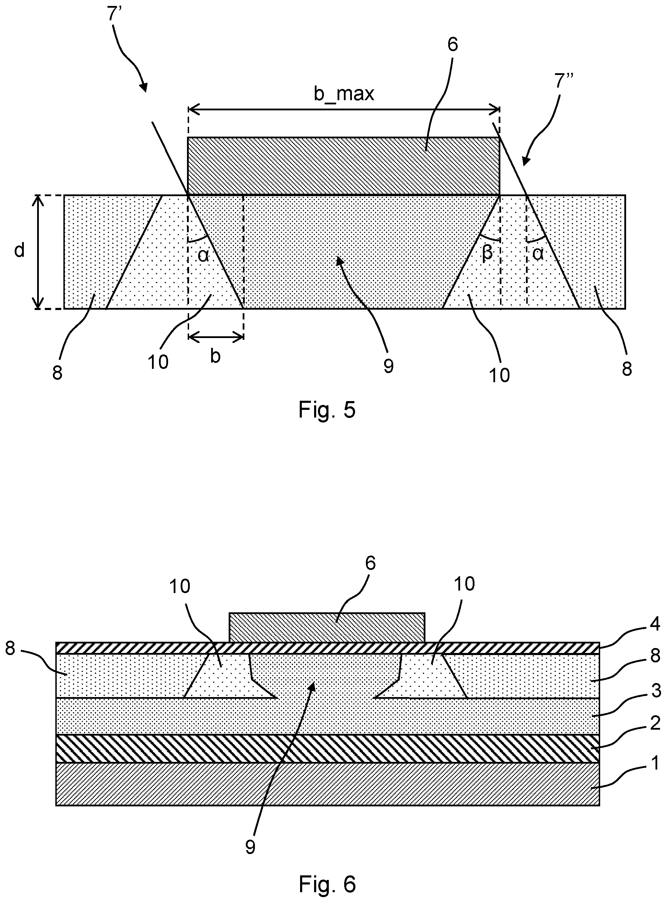

In fig. 5 the JFET region 9 may be seen in greater detail. As may be seen in figs. 3 and 4 two well region types are formed. During the first sub-step there are only second well regions 10 and after the second sub-step there are first well regions 8 (where the implantation 7 of second-conductivity-type dopant happened twice) and second well regions 10 (where the implantation 7 of second-conductivity-type dopant happened once).

As it may be seen in fig. 5 the second well region 10 has a trapezoid shape. It has a height d - impurities were implanted in such depth only during the implantation 7 of second-conductivity-type dopant and thus d is the vertical depth of the well implant. In this example two legs of the trapezoid being the second well region 10 are the same, however angles $\alpha$ and $\beta$, which are the angles of a first implantation path 7' and a second implantation path 7" of the first and the second sub-step of the implantation 7 of second-conductivity-type dopant, may be different. It will also result in an asymmetrical narrowing in the JFET region 9. As it may be seen the JFET region, in its widest point, will have a $b_{max}$ size, which is a size of the first mask 6. The narrowing may not close the JFET region and thus there is a limit for both angles $\alpha$ and $\beta$. In the case of $\alpha=\beta$ the maximum angle may be defined as:

$$\alpha_{max} = arctan\left(\frac{b_{max}}{2d}\right)$$

The angles $\alpha$ and $\beta$ may have any value from slightly greater than 0 to $\alpha_{max}$ as described hereinbefore.

It should be noted that in fig. 5, and next figures, the illustration is simplified. Part of the implant should be directly below the first mask 6. In other words, the cornered shape should be shifted slightly to the centre due to first implantation path 7' being able to penetrate the corner of the first mask 6. However, for the simplification, it is not shown in most figures and more realistic cross section is presented in fig. 6.

In fig. 6 the JFET region is shown the case in which the first mask's 6 penetration depth is not negligible. In such a case the second well regions 10 will not have a trapezoidal shape but the narrowing will still occur. However it should be noted that the first mask 6 with a better quality (greater absorption of the impurities) is recommended. In one example the first mask 6 fully protects the first-conductivity-type epitaxy layer 2 from doping. In another example the first mask 6 has a lower penetration depth than first-conductivity-type epitaxy layer 2.

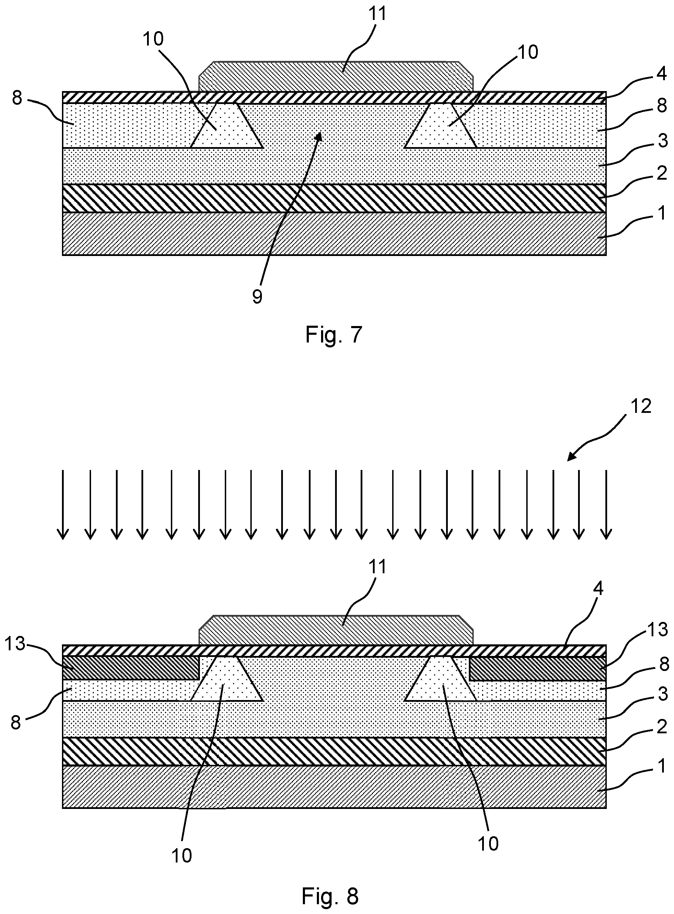

In fig. 7 a final effect of a next step is shown which is a formation of a second mask 11. It should be noted that preferably the second mask 11 is created by adding more spacers to the first mask 6, effectively resulting in a mask wider than the first mask 6.

In fig. 8 a second implantation 12 of first-conductivity-type dopant is shown. This step results in a creation of the source regions 13.

Subsequent manufacturing of gate oxides, terminal contacts at gate/drain/source, interlayer dielectrics, metallizations and passivations are done to complete the device, as typically is done during a standard manufacturing process. These steps are not a key feature of the device and are therefore not described in a greater detail since the person skilled in the art will know how to finish a product as described in this application.

The key element of this invention is a notched well shape in the JFET region. As a consequence, the JFET region is narrower at its bottom part. Additionally, due to the superposition of the two angled implantation steps, a lateral gradient of the well toward the JFET region is present.

A final product of the above mentioned process will be described. It should be however noted that other manufacturing processes may be used as long as the semiconductor device with the narrowing in the JFET region 8 will be present. One may imagine providing layer by layer, wherein in each layer the JFET region 8 will be slightly larger, however, in the Applicant opinion, the method presented hereinbefore will be the most practical and cost effective.

The semiconductor device comprising a first-conductivity-type substrate 1, a first-conductivity-type epitaxy layer 2 comprising a JFET region 9, two first well regions 8 comprising two source regions 13, and two second well regions 10. The first-conductivity-type substrate 1 is adjacent to the first-conductivity-type epitaxy layer 2. The two first well regions 8 are adjacent to the first-conductivity-type epitaxy layer 2 and each of the two first well regions 8 is adjacent to at least one second well region 10. The JFET region 9 is adjacent to the two second well regions 10. A width of the JFET region 9 is greater near a top surface than in part closest to the first-conductivity-type substrate 1. The top surface is a surface of the semiconductor device where first well regions 8 and second well regions 10 are located.

The semiconductor device, as a finished product, comprising a first-conductivity-type substrate 1, a first-conductivity-type epitaxy layer 2 comprising a JFET region 9, two first well regions 8 comprising two source regions 13, two second well regions 10, a gate oxide comprising a gate, a drain adjacent to the first-conductivity-type substrate 1. The first-conductivity-type substrate 1 is adjacent to the first-conductivity-type epitaxy layer 2. The two first well regions 8 are adjacent to the first-conductivity-type epitaxy layer 2 and each of the two first well regions 8 is adjacent to at least one second well region 10. The JFET region 9 is adjacent to the two second well regions 10. A width of the JFET region 9 is greater near a top surface than in part closest to the first-conductivity-type substrate 1. The top surface is a surface of the semiconductor device where first well regions 8 and second well regions 10 are located. A source contact region is the outermost layer and is adjacent to the two source regions 13. The gate oxide is adjacent to the two first well regions 8, the two second well regions 10, the two source regions 13, and the JFET region 9.

In another embodiment the semiconductor device the change in the width of the JFET region 8 is at least partially continuous and linear, preferably the change in the width of the JFET region 8 is continuous and linear.

In another embodiment at least one side of the JFET region 8 being a continuous and linear part of the change of the width of the JFET region 8 forms an angle with a normal of the scatter oxide layer 4, wherein the angle is greater than 0 degrees and wherein there is a gap between both sides of the JFET region. Preferably each of both sides of the JFET region 8 being a continuous and linear part of the change of the width of the JFET region 8 forms the same angle, in terms of an absolute value, with a normal of the scatter oxide layer 4. Even more preferably the angle is smaller than $\arctan(0{,}5b_{max}/d)$, where b is the width of the JFET region 8 closest to the scatter oxide layer 4 and d is a depth of the second well region.

In yet another embodiment the first-conductivity-type epitaxy layer 2 comprising a second first-conductivity-type layer 3 such that at least JFET region 8 is located within the second first-conductivity-type layer 3, wherein the second-conductivity-type layer 3 has a higher dopant concentration than the first-conductivity-type epitaxy layer 2.

LIST OF REFERENCE NUMERALS USED

1    first-conductivity type substrate
2    first-conductivity-type epitaxy layer
3    second-conductivity-type layer
4    scatter oxide layer
5    first implantation of first-conductivity-type dopant
6    first mask
7    implantation of second-conductivity-type dopant
7'    first implantation path
7"    second implantation path
8    first well region
9    JFET region
10    second well region
11    second mask
12    second implantation of first-conductivity-type dopant
13    source region

**Claims**

1. A semiconductor device comprising:

    a first-conductivity-type substrate (1),
    a first-conductivity-type epitaxy layer (2) comprising a JFET region (9),
    two first doped well regions (8) comprising two source regions (13),
    two second well regions (10),
    a source contact region,
    a gate oxide comprising a gate,
    a drain adjacent to the first-conductivity-type substrate (1),
    wherein the first-conductivity-type substrate (1) is adjacent to the first-conductivity-type epitaxy layer (2),
    wherein the two first well regions (8) are adjacent to the first-conductivity-type epitaxy layer (2) and each of the two first well regions (8) is adjacent to at least one second well region (10),
    wherein the JFET region (9) is adjacent to the two second well regions (10),
    wherein a width of the JFET region (9) is greater near a top surface than in part closest to the first-conductivity-type substrate (1), wherein the top surface is a surface of the semiconductor device where first well regions (8) and second well regions (10) are located,
    wherein the source contact region is the outermost layer and is adjacent to the two source regions (13),
    wherein the gate oxide is adjacent to the two first well regions (8), the two second well regions (10), the two source regions (13), and the JFET region (9).

2. The semiconductor device according to claim 1, wherein a change in the width of the JFET region (8) is at least partially continuous and linear.

3. The semiconductor device according to claim 2, wherein the change in the width of the JFET region (8) is continuous and linear.

**4.** The semiconductor device according to claim 2 of 3, wherein at least one side of the JFET region (8) being a continuous and linear part of the change of the width of the JFET region (8) forms an angle with a normal of the scatter oxide layer (4), wherein the angle is greater than 0 degrees and wherein there is a gap between both sides of the JFET region.

**5.** The semiconductor device according to claim 4, wherein each of both sides of the JFET region (8) being a continuous and linear part of the change of the width of the JFET region (8) forms the same angle, in terms of an absolute value, with a normal of the scatter oxide layer (4).

**6.** The semiconductor device according to claim 5, wherein the angle is smaller than $\arctan(0,5b_{max}/d)$, where b is the width of the JFET region (8) closest to the scatter oxide layer (4) and d is a depth of the second well region.

**7.** The semiconductor device according to anyone of the previous claims, wherein the first-conductivity-type epitaxy layer (2) comprising a second first-conductivity-type layer (3) such that at least JFET region (8) is located within the second first-conductivity-type layer (3), wherein the second-conductivity-type shield region (7) has a higher dopant concentration than the first-conductivity-type epitaxy layer (2).

**8.** A method of manufacturing a semiconductor device according to anyone of the claims 1-7, comprising steps of:

a) depositing of a first-conductivity-type epitaxy layer (2) on top of a first-conductivity-type substrate (1),
b) depositing of a scatter oxide layer (4) on top of the first-conductivity-type epitaxy layer (2),
c) creating a first mask (6) on the scatter oxide layer (4),
d) implanting of a dopant by implantation (7) of second-conductivity-type dopant in the area of both first well region (8) and one second well region (10) such that implantation (7) of second-conductivity-type dopant is performed tilted, toward a first side, with respect to a normal of the scatter oxide layer (4),
e) implanting of a dopant by implantation (7) of second-conductivity-type dopant in the area of both first well region (8) and other second well region (10) such that implantation (7) of second-conductivity-type dopant is performed tilted, toward other side, with respect to a normal of the scatter oxide layer (4),
f) creating the second mask (11) which is wider than the first mask (6),
g) creating source regions (13) by second implantation (12) of first-conductivity-type dopant through the second mask (11).

**9.** The method of manufacturing a semiconductor device according to claim 8, wherein the first mask (6) fully protects the first-conductivity-type epitaxy layer (2) from doping during steps d) and e).

**10.** The method of manufacturing a semiconductor device according to claim 8, wherein the first mask (6) has a lower penetration depth than first-conductivity-type epitaxy layer (2).

**11.** The method of manufacturing a semiconductor device according to anyone of claims 8-10, wherein after step b), a second first-conductivity-type layer (3) is created by a first implantation (5) of first-conductivity-type dopant on the first-conductivity-type epitaxy layer (2).

**12.** The method of manufacturing a semiconductor device according to anyone of claims 8-11, wherein during step f), the second mask (11) is created by adding spacers to the first mask (6).

**13.** The method of manufacturing a semiconductor device according to anyone of claims 8-12, wherein implantation (7) of second-conductivity-type dopant is performed tilted during steps d) and e) is tilted by the same angle, in terms of an absolute value.

Fig. 1

Fig. 2

Fig. 3

Fig. 4

Fig. 5

Fig. 6

Fig. 7

Fig. 8

Europäisches
Patentamt

European
Patent Office

Office européen
des brevets

# EUROPEAN SEARCH REPORT

**Application Number**

**EP 23 20 1069**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/282744 A1 (SUNDARESAN SIDDARTH [US] ET AL) 7 September 2023 (2023-09-07) | 1-6, 8-10,12, 13 | INV. H01L29/10 H01L21/265 |
| Y | * paragraph [0092] – paragraph [0094]; figure 1A * * paragraph [0111] – paragraph [0112]; figure 2B * * paragraph [0145] – paragraph [0160]; figures 6A-6Q * | 7,11 | H01L29/66 H01L29/78 |
| Y | US 2021/242319 A1 (SHERIDAN DAVID [US] ET AL) 5 August 2021 (2021-08-05) * paragraph [0047]; figures 4A-4B * * paragraph [0054]; figure 5B * | 7,11 | |
| A | US 2022/069138 A1 (HAN KIJEONG [US] ET AL) 3 March 2022 (2022-03-03) * paragraph [0097] – paragraph [0105]; figures 6A-6E * * paragraph [0121] – paragraph [0123]; figures 9A-9F * | 1-13 | |
| | | | TECHNICAL FIELDS SEARCHED (IPC) |
| A | US 9 240 476 B2 (CREE INC [US]) 19 January 2016 (2016-01-19) * column 4, line 65 – column 7, line 24; figures 2A-2E * | 1-13 | H01L |

The present search report has been drawn up for all claims

| Place of search | Date of completion of the search | Examiner |
|---|---|---|
| Munich | 22 March 2024 | Lantier, Roberta |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

............................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 20 1069

This annex lists the patent family members relating to the patent documents cited in the above-mentioned European search report.
The members are as contained in the European Patent Office EDP file on
The European Patent Office is in no way liable for these particulars which are merely given for the purpose of information.

22-03-2024

| Patent document cited in search report | | | Publication date | Patent family member(s) | | | Publication date |
|---|---|---|---|---|---|---|---|
| US 2023282744 | A1 | | 07-09-2023 | NONE | | | |
| US 2021242319 | A1 | | 05-08-2021 | CN | 113206153 | A | 03-08-2021 |
| | | | | TW | 202143481 | A | 16-11-2021 |
| | | | | US | 2021242319 | A1 | 05-08-2021 |
| US 2022069138 | A1 | | 03-03-2022 | CN | 116325171 | A | 23-06-2023 |
| | | | | EP | 4205182 | A1 | 05-07-2023 |
| | | | | JP | 2023539577 | A | 15-09-2023 |
| | | | | KR | 20230050446 | A | 14-04-2023 |
| | | | | US | 2022069138 | A1 | 03-03-2022 |
| | | | | WO | 2022046444 | A1 | 03-03-2022 |
| US 9240476 | B2 | | 19-01-2016 | CN | 105210193 | A | 30-12-2015 |
| | | | | EP | 2973721 | A1 | 20-01-2016 |
| | | | | JP | 6438933 | B2 | 19-12-2018 |
| | | | | JP | 2016514373 | A | 19-05-2016 |
| | | | | KR | 20150125688 | A | 09-11-2015 |
| | | | | US | 2014264579 | A1 | 18-09-2014 |
| | | | | WO | 2014164290 | A1 | 09-10-2014 |

EPO FORM P0459

For more details about this annex : see Official Journal of the European Patent Office, No. 12/82

**EP 4 531 110 A1**

**Patent documents cited in the description**

- US 9184230 B2
- US 7728336 B2
- JP 5368140 B
- JP 5300658 B